Europäisches Patentamt

European Patent Office

Office européen des brevets

(19)

(11) Numéro de publication: **0 379 113**
**A1**

## (12) DEMANDE DE BREVET EUROPEEN

(21) Numéro de dépôt: **90100714.6**

(51) Int. Cl.⁵: **H04L 27/22, H03L 7/12**

(22) Date de dépôt: **15.01.90**

(30) Priorité: **18.01.89 FR 8900537**

(43) Date de publication de la demande:
**25.07.90 Bulletin 90/30**

(84) Etats contractants désignés:
**DE ES FR GB IT NL SE**

(71) Demandeur: **ALCATEL TRANSMISSION PAR FAISCEAUX HERTZIENS A.T.F.H.**
**55, rue Greffulhe**
**F-92301 Levallois-Perret Cédex(FR)**

(72) Inventeur: **Janer, Patrick**
**4 rue Voltaire**
**F-92300 Levallois Perret(FR)**

(74) Mandataire: **Weinmiller, Jürgen et al**
**Lennéstrasse 9 Postfach 24**
**D-8133 Feldafing(DE)**

(54) **Dispositif de récuperation de porteuse insensible aux faux accrochages.**

(57) La présente invention se rapporte à un dispositif de récupération de porteuse insensible aux faux accrochages du signal référence sur le signal à démoduler en démodulation numérique cohérente, dans lequel un signal perturbateur (Vosc) est sommé au signal de tension de boucle (Vd) de manière à entraîner un décrochage de la boucle lors d'un faux accrochage.

Application notamment au domaine des faisceaux hertziens numériques.

FIG.5

EP 0 379 113 A1

## Dispositif de récupération de porteuse insensible aux faux accrochages

L'invention concerne un dispositif de récupération de porteuse insensible aux faux accrochages (ou "false-locks" en langue anglaise) du signal référence sur le signal à démoduler en démodulation numérique cohérente, et notamment dans le domaine des faisceaux hertziens numériques.

Un premier type de chaînes de réception, classiques en hyperfréquences, comporte en série après l'antenne de réception un filtre de bande hyperfréquence suivi d'un amplificateur faible bruit, puis un mélangeur réalisant une transposition en fréquence intermédiaire au moyen d'un oscillateur local de réception. Une telle chaîne comporte ensuite un préamplificateur à fréquence intermédiaire, des cellules de correction de temps de propagation de groupe, et un amplificateur à fréquence intermédiaire. Le circuit de démodulation du signal à fréquence intermédiaire permet alors de restituer le signal en bande de base, le signal codé étant restitué après traitement du signal en bande de base. Dans de telles chaînes de réception, la double transposition d'hyperfréquence en fréquence intermédiaire, puis de fréquence intermédiaire en bande de base, conduit à utiliser tout un ensemble de circuits en fréquence intermédiaire, avec en particulier un oscillateur local.

Un second type de chaîne de réception hyperfréquence permet de réaliser à partir d'un signal hyperfréquence reçu, une démodulation directe avec un nombre réduit d'éléments, les circuits à fréquence intermédiaire étant supprimés.

Ainsi le brevet US 4 559 499 décrit un dispositif de démodulation directe, en hyperfréquence, d'un signal modulé en phase par des signaux numériques, qui comporte un circuit de modulation, dont l'entrée est couplée à l'entrée de signal reçu, associé à un oscillateur à la fréquence porteuse du signal reçu, commandable pour que la phase de la porteuse issue de l'oscillateur coïncide avec la phase du signal reçu, le circuit de démodulation comportant un séparateur relié aux premières entrées de deux mélangeurs symétriques, un coupleur introduisant sur l'une des voies un déphasage de 90° dont les sorties sont reliées aux secondes entrées des deux mélangeurs, et des filtres passe-bas reliés aux sorties des mélangeurs délivrant les signaux numériques démodulés.

Dans tout système à démodulation cohérente, il est nécessaire d'avoir une référence de phase, celle-ci est obtenue par récupération de la porteuse : l'information est en effet contenue dans la phase de cette porteuse.

Quel que soit le type de démodulation, il existe, du fait notamment de la dérive en température de l'oscillateur utilisé, par exemple VCO ("voltage control oscillator"), des "faux accrochages" du signal référence sur le signal à démoduler, pour lesquels on obtient une information de phase erronée. Ces faux accrochages sont situés, dans le cas d'une modulation quatre états de phase par exemple, aux multiples du quart du débit numérique de part et d'autre de la fréquence centrale.

L'invention a pour objet un dispositif qui se montre insensible à de tels faux accrochages.

Elle propose à cet effet un dispositif de récupération de porteuse insensible aux faux accrochages du signal référence sur le signal à démoduler en démodulation numérique cohérente, dans lequel un signal perturbateur est sommé au signal de tension de boucle de manière à entraîner un décrochage de la boucle lors d'un faux accrochage, caractérisé en ce que la fréquence (Fosc) du signal perturbateur est comprise entre la bande de boucle avec un mauvais accrochage (Bfa) et la bande de boucle (Bb) avec un bon accrochage.

Les avantages de ce dispositif sont :
- sa très grande simplicité de mise en oeuvre, l'oscillateur pouvant être réalisé avec une porte logique ou un amplificateur opérationnel,
- son faible coût,
- sa faible consommation,
- sa rapidité d'acquisition,
- son utilisation pour des débits très faibles en démodulation directe.

Les caractéristiques et avantages de l'invention ressortiront d'ailleurs de la description qui va suivre, à titre d'exemple non limitatif, en référence aux figures annexées sur lesquelles :
- Les figures 1 à 4 illustrent le fonctionnement d'un dispositif de l'art antérieur ;
- Les figures 5 et 6 illustrent le fonctionnement du dispositif de l'invention ;
- La figure 7 illustre un récepteur selon l'invention.

Dans la suite de la description la démodulation considérée sera une démodulation directe à quatre états de phase, mais l'invention n'est absolument pas limitée à ce type de modulation.

Cet exemple a été choisi car une démodulation directe à faible débit accentue le phénomène de faux accrochages.

En démodulation numérique, qu'elle soit effectuée en hyperfréquence ou en fréquence intermédiaire, il existe des faux accrochages. Ces faux accrochages sont situés aux multiples du quart du débit numérique de part et d'autre de la fréquence centrale.

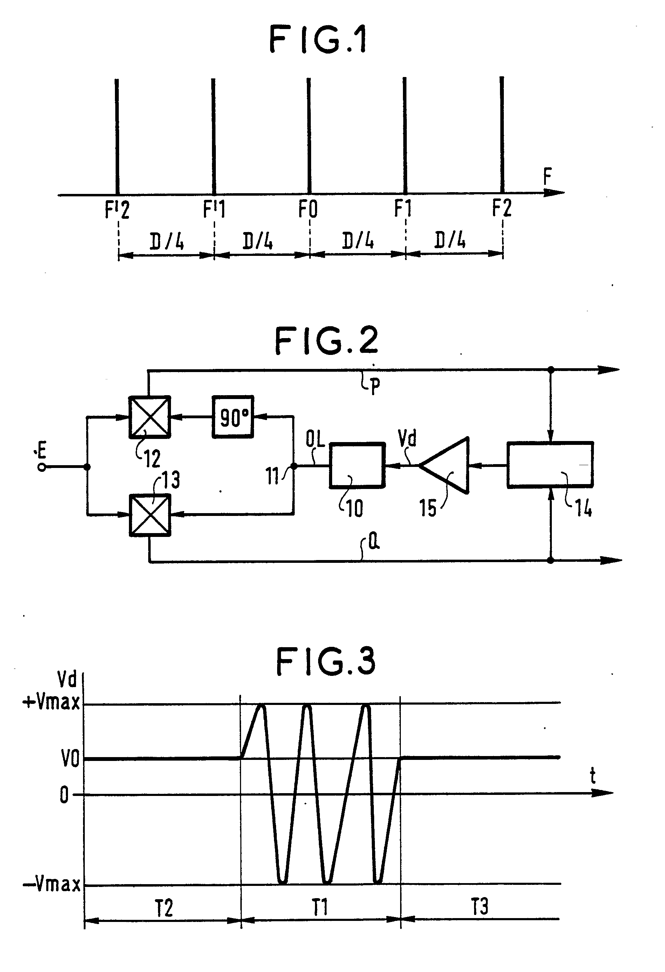

Ainsi sur la figure 1 est représenté le plan de fréquence des faux accrochages, avec :
- Fo : fréquence de la porteuse,

- F'2, F'1, F1, F2 : fréquences des faux accrochages,
- D : débit numérique.

En cas de faux accrochage de la porteuse locale sur la porteuse reçue, les signaux reçus sont erronés mais au bon débit. La récupération de rythme est donc possible.

La difficulté dans la conception d'une boucle de récupération de porteuse insensible aux faux accrochages réside dans la réalisation d'une boucle :
- ayant un accrochage très stable sur Fo (bon accrochage),
- ayant une instabilité inconditionnelle sur les fréquences des faux accrochages,
- conservant de bonnes caractéristiques en bruit et en bande passante nécessaire pour le démodulateur.

Dans une boucle d'accrochage classique, telle que représentée à la figure 2, le signal E reçu en entrée est constitué de deux porteuses en quadrature de phase modulées par deux signaux numériques synchrones et formant un signal modulé à quatre états de phase. Ce circuit comporte également une entrée de signal d'oscillation locale OL reliée à la sortie d'un oscillateur 10 commandé en tension.

L'entrée de signal d'oscillation locale OL est reliée à l'entrée d'un coupleur 3 dB (11), dont les sorties sont déphasées l'une par rapport à l'autre de 90°. Les deux sorties de ce coupleur 3 dB, sont reliées aux secondes entrées de deux mélangeurs linéaires 12 et 13 dont les premières entrées reçoivent le signal d'entrée E. La fréquence de l'oscillateur local est égale à la fréquence porteuse du signal reçu.

L'oscillateur commandé en tension ou VCO est inséré dans la boucle à verrouillage de phase, permettant de le synchroniser sur l'oscillateur émission.

* Vd est la tension de boucle commandant en fréquence le VCO et asservissant sa fréquence de façon continue (variation de la fréquence du VCO due aux variations de température, d'alimentation....).

* P et Q sont les signaux numériques démodulés.

Le signal présent à l'entrée du démodulateur numérique est une onde modulée en phase. Dans le spectre de ce signal, il n'existe pas de porteuse non modulée. Pour obtenir une démodulation cohérente, le récepteur doit reconstituer cette porteuse qui devra être synchrone de l'onde émise.

Un estimateur de phase 14, suivi ici d'un amplificateur de boucle 15, a pour rôle d'obtenir une référence de phase stable afin d'extraire de façon correcte les différents sauts de phase porteurs de l'information par le circuit de démodulation.

Dans la chaîne de réception, avec démodulation directe, l'estimateur de phase 14 fonctionne par exemple à partir d'un système de démodulation à boucle de COSTAS. Dans ce type de système, la tension d'erreur e, nécessaire pour verrouiller la boucle de phase, est obtenue directement à partir des deux signaux démodulés. En effet, il est possible d'obtenir, à partir de ces deux signaux, un signal d'erreur caractéristique du déphasage 0 entre la porteuse reçue et le signal d'oscillation locale.

L'oscillateur de réception est donc inséré dans une boucle à verrouillage de phase qui est déterminée par l'estimateur de costas 14. Cet estimateur 14 est périodique et possède une caractéristique en sin(4.0) (0 étant l'erreur de phase estimée).

La boucle comprend généralement un oscillateur de recherche commandé lors d'un décrochage de la boucle (coupure ou forte atténuation du signal à l'entrée du récepteur).

La figure 3 montre un chronogramme du signal de commande du VCO lors d'un décrochage de la porteuse.

* Vo est la tension appliquée au VCO dans le cas d'un bon accrochage.

* Vmax est l'amplitude du signal de recherche commandant le VCO.

* T1 est la zone de décrochage.

* T2 et T3 les zones d'accrochage.

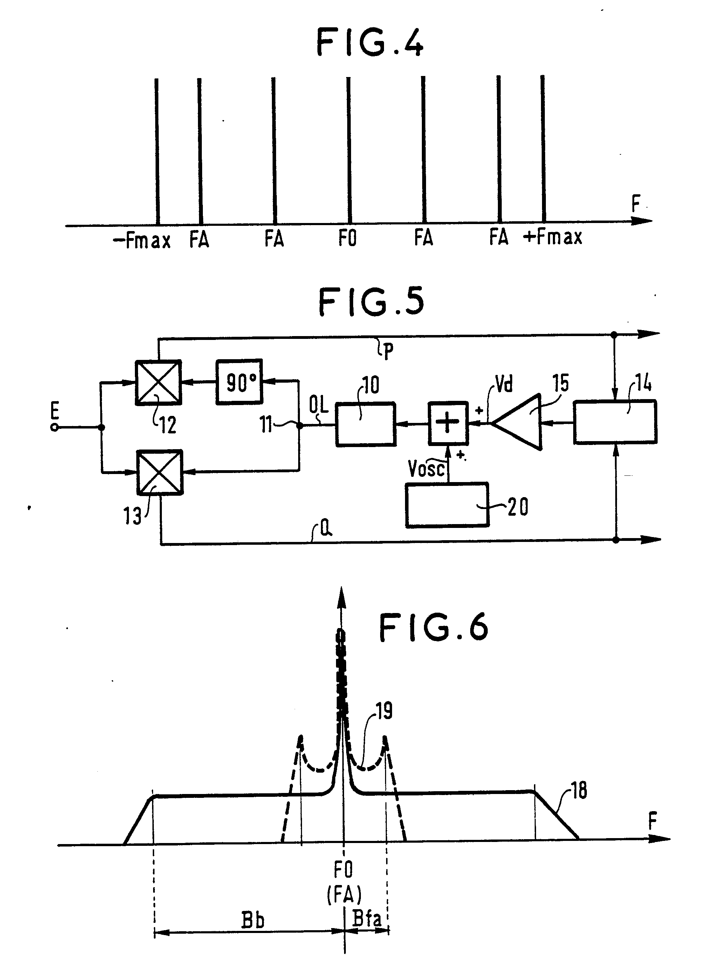

Lors d'une démodulation directe en hyperfréquence par exemple, la dérive du VCO (bande +- Fmax autour de Fo), comme représenté à la figure 4, est supérieure à la plage de fréquence des faux accrochages FA.

L'amplitude (Vmax) de la tension de boucle (Vd) en phase de recherche, doit être suffisante pour excursionner le VCO sur +- Fmax autour de Fo. Suivant la dérive maximum de l'oscillateur utilisé, le VCO peut s'accrocher sur un ou plusieurs faux accrochages.

Des boucles de ce type ne conviennent donc pas ; car lors d'un décrochage de la porteuse, les risques de faux accrochages de cette dernière sont très importants.

Dans la boucle selon l'invention, telle que représentée à la figure 5, les éléments communs avec les éléments de la boucle classique représentée à la figure 2 ont gardé les mêmes références.

Cette nouvelle boucle comprend en plus de la boucle classique de type Costas, un oscillateur basse fréquence 20.

Le signal Vosc de l'oscillateur BF 20 est sommé à celui de la tension de boucle Vd. Le signal de commande du VCO hyperfréquence 10 est donc la somme du signal d'erreur Vd et du signal Vosc de l'oscillateur BF.

Lors d'un faux accrochage (FA) le signal démodulé est constitué d'une porteuse (FA-Fo) modulée en phase. Bien que ces signaux ne soient pas des signaux binaires, l'estimateur de phase les traite comme tels du fait du synchronisme existant entre la période de la porteuse (FA-Fo) et la durée des éléments binaires. L'estimateur de costas 14 traite ces signaux comme des signaux numériques fortement bruités. La sensibilité de cet estimateur étant fortement diminuée par la nature de ces signaux, la bande de boucle du système lors d'un faux accrochage est donc très faible.

La figure 6 montre la variation de la bande de boucle, lors d'un bon (18) et d'un mauvais (19) accrochage, avec :
- Bb : bande de boucle avec un bon accrochage ;
- Bfa : bande de boucle avec un mauvais accrochage ;
- Fo : fréquence de la porteuse (lors d'un bon accrochage) ;
- FA : fréquence de la porteuse (lors d'un mauvais accrochage).

En choisissant judicieusement la fréquence Fosc de l'oscillateur BF 20 en fonction de la bande passante de boucle (en boucle fermée), la boucle devient insensible aux faux accrochages.

Si la fréquence de l'oscillateur BF 20 reste inférieure à Bb (bande de boucle avec un bon accrochage), elle ne perturbe pas la boucle lors d'un bon accrochage. Le VCO hyperfréquence 10 n'est pas modulé en fréquence, la fréquence de l'oscillateur étant à l'intérieur de la bande de boucle, cette dernière compense la tension Vosc et le VCO hyperfréquence reste synchrone de la porteuse émission.

Si la fréquence de l'oscillateur BF 20 est supérieure à Bfa (bande de boucle avec un faux accrochage), lors d'un faux accrochage, le VCO hyperfréquence est modulé en fréquence avec la fréquence Fosc. Le VCO hyperfréquence n'est donc plus synchrone de l'émission, il n'y a plus synchronisme entre la période (Fo-FA) et la durée des éléments binaires, alors la boucle ne peut pas se verrouiller sur cette fréquence (faux accrochage).

La fréquence Fosc doit donc être comprise entre Bfa et Bb.

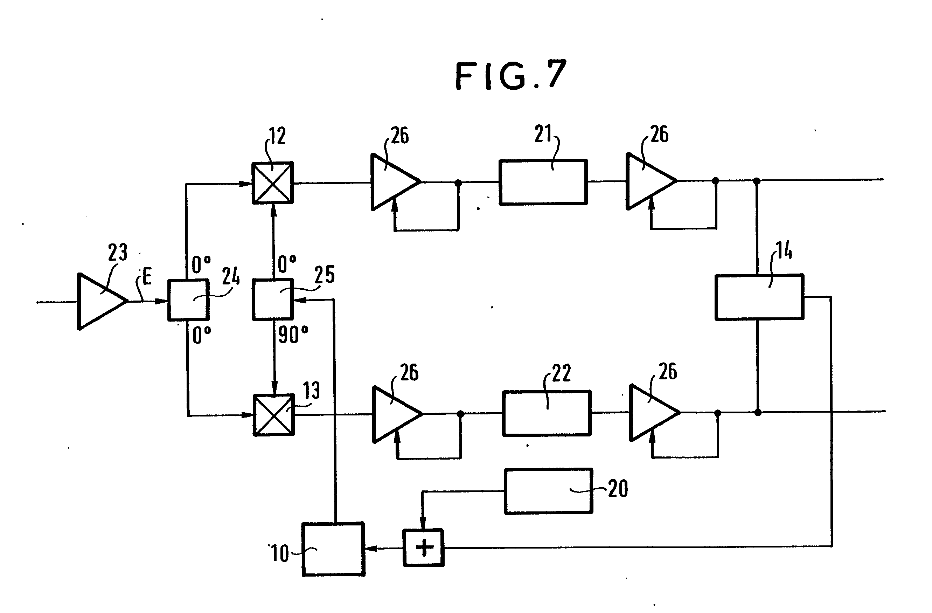

Le récepteur, représenté à la figure 7, comprend les mêmes circuits que ceux représentés à la figure 5. Il comprend de plus en entrée un amplificateur faible bruit 23, un coupleur 24 (0°, 0°), et un coupleur 25 (0°, 90°), et des amplificateurs 26 fonctionnant en adaptateurs.

Dans un exemple de réalisation, ce récepteur est un récepteur à démodulation directe dans la bande 2.3/2.5 GHz. La fréquence du canal est 2472 MHz. Le débit numérique est de 8.945 Mbit/s. Sur chaque voie le filtrage bande de base (après les mélangeurs 12 et 13) est réalisé avec un filtre (21, 22) de type butterworth 5 pôles dont la fréquence de coupure à -3dB est de 10 MHz.

La bande de boucle du système de récupération de porteuse est de 200 kHz sur un bon accrochage et avec une surtension (remontée) de 4 dB.

La bande de boucle de ce même système est de 23 kHz sur un faux accrochage avec une surtension de 10 dB.

L'oscillateur délivre un signal de fréquence 30 kHz et d'amplitude 250 mV crête-à-crête environ. L'amplitude de ce signal dépend évidemment de la sensibilité du VCO hyperfréquence.

La bande de boucle avec ce système reste inchangée.

Le système réalisé utilise donc un oscillateur fonctionnant entre 20 et 30 kHz. La bande de boucle avec un bon accrochage est de 200 kHz alors qu'avec un faux accrochage, elle est inférieure à 25 kHz.

Il est bien entendu que la présente invention n'a été décrite et représentée qu'à titre d'exemple préférentiel et que l'on pourra remplacer ses éléments constitutifs par des éléments équivalents sans pour autant sortir du cadre de l'invention.

## Revendications

1/ Dispositif de récupération de porteuse insensible aux faux accrochages du signal référence sur le signal à démoduler en démodulation numérique cohérente, dans lequel un signal perturbateur (Vosc) est sommé au signal de tension de boucle (Vd) de manière à entraîner un décrochage de la boucle lors d'un faux accrochage, caractérisé en ce que la fréquence (Fosc) du signal perturbateur est comprise entre la bande de boucle avec un mauvais accrochage (Bfa) et la bande de boucle (Bb) avec un bon accrochage.

2/ Dispositif selon la revendication 1, caractérisé en ce que le signal perturbateur est injecté lors de l'émission du signal.

3/ Dispositif selon la revendication 1, caractérisé en ce que le signal perturbateur est injecté lors de la réception du signal.

4/ Dispositif selon la revendication 1, caractérisé en ce que le signal perturbateur est un signal BF.

# FIG.1

F'2    F'1    F0    F1    F2    F

D/4    D/4    D/4    D/4

# FIG.2

# FIG.3

# FIG.4

$-Fmax \quad FA \quad\quad FA \quad\quad F0 \quad\quad FA \quad\quad FA \quad +Fmax$

$F$

# FIG.5

# FIG.6

$F0$
$(FA)$

$Bb$ | $Bfa$

$F$

# FIG.7

EP 0 379 113 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-4 092 606 (RYAN)<br>* En entier *<br>--- | 1 | H 04 L 27/22<br>H 03 L 7/12 |
| A | PROCEEDINGS OF THE IEE-F, vol. 127, no. 2, avril 1980, pages 163-167, Stevenage, US; P.K. BLAIR et al.: "Receivers for the NAVSTAR global positioning system"<br>* Page 165, colonne de droite, ligne 2 - page 166, colonne de droite, ligne 20; figures 2-5 *<br>--- | 1 | |
| A | US-A-4 314 206 (ATTWOOD et al.)<br>* Colonne 1, ligne 35 - colonne 2, ligne 31; figure *<br>--- | 1 | |
| A | US-A-4 157 514 (NAITO et al.)<br>* Colonne 2, ligne 5 - colonne 10, ligne 58; figures 5-9 *<br>--- | 1 | |
| A | EP-A-0 120 786 (THOMSON-CSF)<br>----- | | **DOMAINES TECHNIQUES RECHERCHES (Int. Cl.5)**<br><br>H 04 L<br>H 03 L |

Le présent rapport a été établi pour toutes les revendications

| Lieu de la recherche | Date d'achèvement de la recherche | Examinateur |
|---|---|---|
| LA HAYE | 25-04-1990 | DHONDT I.E.E. |